# EUROPÄISCHE PATENTSCHRIFT

(11) **EP 4 073 486 B1**
(45) Veröffentlichungstag und Bekanntmachung des Hinweises auf die Patenterteilung: **07.08.2024**
(21) Anmeldenummer: 20838339.8
(22) Anmeldetag: 08.12.2020
(51) Int. Cl.: G01M 5/00, G01B 21/04, G01B 21/32, G01B 11/16

(54) **VERFAHREN UND VORRICHTUNG ZUM BESTIMMEN VON AUFWERTE-FAKTOREN FÜR DEHNUNGSMESSUNGEN AN MASCHINENELEMENTEN**
METHOD AND APPARATUS FOR DETERMINING UPVALUE FACTORS FOR EXPANSION MEASUREMENTS ON MACHINE ELEMENTS
PROCÉDÉ ET APPAREIL DE DÉTERMINATION DE FACTEURS D'AUGMENTATION DE MESURES D'EXPANSION SUR DES ÉLÉMENTS DE MACHINE

(30) Priorität: 11.12.2019 DE 102019219387
(43) Veröffentlichungstag der Anmeldung: 19.10.2022
(73) Patentinhaber: MTU Aero Engines AG, 80995 München (DE)
(72) Erfinder: RITTINGER, David, 80995 München (DE); RETZE, Ulrich, 80995 München (DE); RESCHKE, Joerg, 80995 München (DE); MEIR, Wilhelm, 80995 München (DE); JUNGE, Michael, 80995 München (DE); SCHWARZ, Stefan, 80995 München (DE)
(86) Internationale Anmeldenummer: PCT/DE2020/000322
(87) Internationale Veröffentlichungsnummer: WO 2021/115512

(56) Entgegenhaltungen:
- EP-B1- 1 922 537
- DE-A1- 10 105 994
- DE-A1- 102011 011 392
- DE-A1- 102016 108 991
- FR-A1- 2 956 734

## Beschreibung

Die vorliegende Erfindung betrifft ein Verfahren und eine Vorrichtung zum Bestimmen von Aufwertefaktoren für Dehnungsmessungen an Maschinenelementen.

Zur Validierung der schwingungsmechanischen Auslegung von Triebwerksschaufeln wurden bisher in der Entwicklungsphase mit Dehnungsmessstreifen (DMS) die dynamischen Beanspruchungen von Rotorelementen im Rig/Triebwerk gemessen. Dieser experimentelle Nachweis ist für die Zulassung der Bauteile zwingend erforderlich. Da die Anzahl von Messstellen in einem Triebwerk limitiert ist und die DMS für die hohe Anzahl zu messender Schwingformen nicht an den Positionen der maximalen Schwingungsbeanspruchung appliziert werden können, wird mit einer stark reduzierten Anzahl von DMS gearbeitet. Diese werden so gezielt ausgerichtet, dass die einzelnen Sensoren von einer bestimmten Menge von Schwingungsformen einen Teil der mechanischen Beanspruchung erfassen, aber sehr selten das Maximum.

Der konventionelle Weg, von diesen Messpositionen auf die maximale Schwingungsbeanspruchung der einzelnen Schwingformen zu schließen, erfolgt über eine experimentelle Kalibrierung der Schaufeln im Labor. In aufwändigen Laboranalysen werden dabei Faktoren für die einzelnen DMS experimentell bestimmt, mit denen die im Rig/Triebwerk gemessenen Werte multipliziert werden, um auf die tatsächliche maximale Schwingspannung einer Schwingungsform schließen zu können. Für diese Laboranalysen wird eine hohe Anzahl von zusätzlichen Labor-DMS auf dem Schaufelblatt im jeweiligen Dehnungsmaximum der einzelnen Moden appliziert.

Diese Vorgehensweise bei dieser konventionellen Bestimmung von Aufwertefaktoren ist jedoch kostspielig, zeitintensiv und teilweise ungenau.

Bei der konventionellen Ermittlung von Aufwertefaktoren für Maschinenelemente/Bauteile werden die maximalen Dehnungen nur an sehr lokalen Stellen (Labor-DMS-Positionen) gemessen. Diese Stellen wurden zuvor durch Finite-Elemente-Berechnungen definiert. Problematisch ist hier, dass die Position der maximalen Dehnung rein durch Rechnungen festgelegt wird. In der Realität kann sich jedoch die Position der maximalen Dehnung zum Beispiel aufgrund von geometrischen Abweichungen verschieben. Besonders bei hohen Dehnungsgradienten kann somit der durch den Labor-DMS erfasste Wert deutlich von der Maximaldehnung abweichen. Ein weiteres Problem ist die Schwierigkeit, die DMS exakt auf eine definierte Position und Ausrichtung zu applizieren. Somit ist es selbst dann schwierig, die maximale Dehnung mittels DMS zu messen, wenn derer Position und Ausrichtung exakt bekannt sind.

DE 10 2011 011 392 A1 offenbart eine Einrichtung zur optischen Messung von Verformungen eines Rotorblattes einer Windkraftanlage, wobei eine Kamera auf eine Referenzposition einer optisch erfassbaren Verformungsmarkierung gerichtet ist. Abweichungen von der Referenzposition werden ermittelt und quantifiziert.

Die Dissertation "Schaufelschwingungen realer integraler Verdichterräder im Hinblick auf Verstimmung und Lokalisierung" von Thomas Klauke in der Fakultät für Maschinenbau, Elektrotechnik und Wirtschaftsingehieurwesen der Brandenburgischen Technischen Universität Cottbus offenbart eine Applikation eines Folien-DMS auf einen Rotor basierend auf einer Schaufelbiegemode.

EP 1 922 537 B1 offenbart ein Verfahren zur Bestimmung einer Dehnungsverteilung an Gasturbinenbauteilen mit einer Schwingungsanregung des Bauteils und messtechnischem Erfassen einer Schwingwegverteilung des Bauteils für eine Vielzahl von Messpunkten mit Hilfe eines Vibrometers sowie einem Berechnen eines tensoriellen Dehnungszustands und einer Dehnungsverteilung.

Das Dokument FR2956734 A1 offenbart ein weiteres Verfahren zum Bestimmen einer Dehnung bei einem Maschinenelement gemäß dem Stand der Technik.

Eine Aufgabe der vorliegenden Erfindung ist es, ein Verfahren und eine Vorrichtung zum Bestimmen eines Aufwertefaktors für eine Dehnungsmessung bei einem Maschinenelement zu verbessern.

Diese Aufgabe wird durch ein Verfahren zum Bestimmen eines Aufwertefaktors für eine Dehnungsmessung bei einem Maschinenelement mit den Merkmalen des Anspruchs 1 bzw. durch eine Vorrichtung mit den Merkmalen des Anspruchs 8 gelöst.

Vorteilhafte Ausführungsformen der Erfindung sind Gegenstand der Unteransprüche.

Nach einem Aspekt der vorliegenden Erfindung hat ein Verfahren zum Bestimmen eines Aufwertefaktors für eine Dehnungsmessung bei einem Maschinenelement, insbesondere bei einer Blisk, die folgenden Schritte: Anbringen einer Dehn-Mess-Einrichtung an einem Mess-Oberflächenabschnitt des Maschinenelements; Bewirken einer statischen oder dynamischen Verformung des Maschinenelements; Messen einer Dehnung im Mess-Oberflächenabschnitt mithilfe der Dehn-Mess-Einrichtung; Messen einer Verschiebung zumindest eines Erfassungs-Oberflächenabschnitts des Maschinenelements, der sich von dem Mess-Oberflächenabschnitt unterscheidet, durch optisches Abtasten des Maschinenelements; Bestimmen eines Verschiebungsfeldes auf einer Oberfläche des Maschinenelements auf der Grundlage eines Modells des Maschinenelements und der gemessenen Verschiebung des zumindest eines Erfassungs-Oberflächenabschnitts; Bestimmen eines Dehnungsfeldes auf der Oberfläche des Maschinenelements auf der Grundlage des bestimmten Verschiebungsfeldes und des Modells des Maschinenelements; Bestimmen eines Aufwertefaktors der Dehn-Mess-Einrichtung auf der Grundlage der gemessenen Dehnung im Mess-Oberflächenabschnitt und des bestimmten Dehnungsfeldes.

Der Aufwertefaktor ist ein Verhältnis einer maximalen Dehnung im Dehnungsfeld und der gemessenen Dehnung im Mess-Oberflächenabschnitt.

Das erfindungsgemäße Verfahren setzt eine optische Messtechnik ein, mit der die Verschiebungen auf dem Schaufelblatt berührungslos und in einer Teilfläche erfasst werden. Vorzugsweise ist eine Vielzahl von Erfassungs-Oberflächenabschnitten vorhanden, so dass ein großflächiges Verschiebungsfeld des Rotorelements, bestehend aus den Erfassungs- Oberflächenabschnitten, bestimmt wird, und daraus, wie im vorherigen Abschnitt beschrieben, das vorzugsweise vollflächige Dehnungsfeld bestimmt werden kann. Der große Vorteil besteht darin, dass damit Schwingungen des Maschinenelements an einer Teilfläche, d.h. dem von Erfassungs-Oberflächenabschnitt, optisch abgetastet werden und nicht an wenigen, sehr lokalen Positionen, wie es im Stand der Technik bei den im Labor zusätzlich aufgebrachten DMS der Fall war. Das erfindungsgemäße Verfahren verwendet zudem optische Messverfahren, die in der Lage sind, hochempfindlich die räumliche Schwingungsbewegung des Bauteils zu messen, wodurch die Aussagekraft und die Genauigkeit der Aufwertefaktoren gestärkt wird. Hierfür kann ein flächiges, optisches Abtasten insbesondere durch Laservibrometrie oder ein Bildkorrelationsverfahren verwendet werden. Dadurch können auch die Durchlaufzeiten bei der Ermittlung der Aufwertefaktoren für Verdichterblisken verkürzt werden.

Vorzugsweise wird das Modell des Maschinenelements auf der Grundlage von nominalen und/oder insbesondere durch Reverse-Engineering erfassten Daten erstellt und/oder weist finite Elemente auf. Weiter bevorzugt ist das Modell des Maschinenelements ein validiertes Finite-Elemente-Modell des Maschinenelements. Ein validiertes Finite-Elemente-Modell ergibt sich durch den erfolgreichen Durchlauf eines Validierungs-Prozesses, in dem nachgewiesen wird, dass das Modell innerhalb seines Anwendungsgebiets hinreichend genau für die beabsichtige Anwendung ist.

Vorzugsweise hat das Verfahren einen Schritt zum Bestimmen des Mess-, und/oder Erfassungs-Oberflächenabschnitts und einer Orientierung der Dehn-Mess-Einrichtung an dem Mess-Oberflächenabschnitt auf der Grundlage des Modells des Maschinenelements. Weiter bevorzugt hat das Verfahren einen Schritt zum Bestimmen von Schwingungsmoden des Maschinenelements auf der Grundlage des Modells des Maschinenelements, wobei der Mess-Oberflächenabschnitt und die Orientierung der Dehn-Mess-Einrichtung an dem Mess-Oberflächenabschnitt zusätzlich auf der Grundlage der bestimmten Schwingungsmoden bestimmt werden. Dadurch kann die Aussagekraft des Aufwertefaktors noch weiter verbessert werden.

Nach einem anderen Aspekt der vorliegenden Erfindung hat eine Vorrichtung zum Bestimmen eines Aufwertefaktors für eine Dehnungsmessung bei einem Maschinenelement eine Dehn-Mess-Einrichtung, die dazu konfiguriert ist, an einem Mess-Oberflächenabschnitt des Maschinenelements angebracht zu werden; ein Mittel, das dazu konfiguriert ist, eine statische oder dynamische Verformung des Maschinenelements zu bewirken; ein Mittel, das dazu konfiguriert ist, eine Dehnung im Mess-Oberflächenabschnitt mithilfe der Dehn-Mess-Einrichtung zu messen; ein Mittel, das dazu konfiguriert ist, eine Verschiebung zumindest eines Erfassungs-Oberflächenabschnitts des Maschinenelements, der sich von dem Mess-Oberflächenabschnitt unterscheidet, zu messen, durch optisches Abtasten des Maschinenelements; ein Mittel, das dazu konfiguriert ist, ein Verschiebungsfeld auf einer Oberfläche des Maschinenelements auf der Grundlage eines Modells des Maschinenelements und der gemessenen Verschiebung des zumindest eines Erfassungs-Oberflächenabschnitts zu bestimmen; ein Mittel, das dazu konfiguriert ist, ein Dehnungsfeld auf der Oberfläche des Maschinenelements auf der Grundlage des bestimmten Verschiebungsfelds und des Modells des Maschinenelements zu bestimmen; und ein Mittel, das dazu konfiguriert ist, einen Aufwertefaktor der Dehn-Mess-Einrichtung auf der Grundlage der gemessenen Dehnung im Mess-Oberflächenabschnitt und des bestimmten Dehnungsfeldes zu bestimmen. Die erfindungsgemäße Vorrichtung erzielt dieselben Vorteile wie das vorstehend beschriebene, erfindungsgemäße Verfahren.

Ein Mittel im Sinne der vorliegenden Erfindung kann hard- und/oder softwaretechnisch ausgebildet sein, insbesondere eine, vorzugsweise mit einem Speicher- und/oder Bussystem daten- bzw. signalverbundene, insbesondere digitale, Verarbeitungs-, insbesondere Mikroprozessoreinheit (CPU) und/oder ein oder mehrere Programme oder Programmmodule aufweisen. Die CPU kann dazu ausgebildet sein, Befehle, die als ein in einem Speichersystem abgelegtes Programm implementiert sind, abzuarbeiten, Eingangssignale von einem Datenbus zu erfassen und/oder Ausgangssignale an einen Datenbus abzugeben. Ein Speichersystem kann ein oder mehrere, insbesondere verschiedene, Speichermedien, insbesondere optische, magnetische, Festkörper- und/oder andere nicht-flüchtige Medien aufweisen. Das Programm kann derart beschaffen sein, dass es die hier beschriebenen Verfahren verkörpert bzw. auszuführen imstande ist, sodass die CPU die Schritte solcher Verfahren ausführen kann.

In einer Ausführung werden ein oder mehrere, insbesondere alle, Schritte des Verfahrens vollständig oder teilweise automatisiert durchgeführt, insbesondere durch die Vorrichtung bzw. ihre Mittel.

Weitere vorteilhafte Weiterbildungen der vorliegenden Erfindung ergeben sich aus den Unteransprüchen und der nachfolgenden Beschreibung bevorzugter Ausführungen. Hierzu zeigt, teilweise schematisiert:
- Fig. 1: ein Maschinenelement, bei dem ein Aufwertefaktor für eine Dehnungsmessung nach einer Ausführung der vorliegenden Erfindung bestimmt wird; und
- Fig. 2: ein Flussdiagramm eines Verfahrens zum Bestimmen des Aufwertefaktors für eine Dehnungsmessung bei dem Maschinenelement.

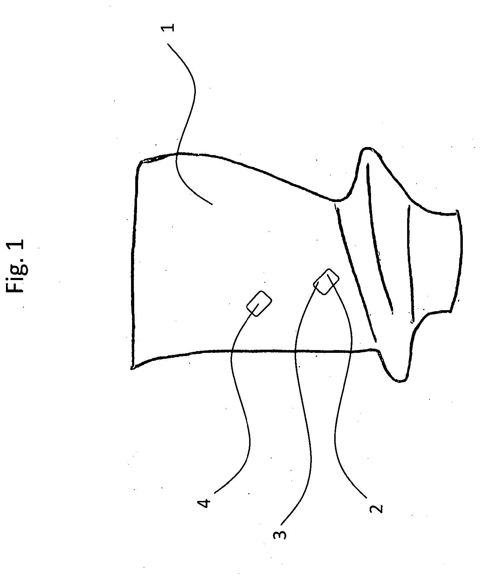

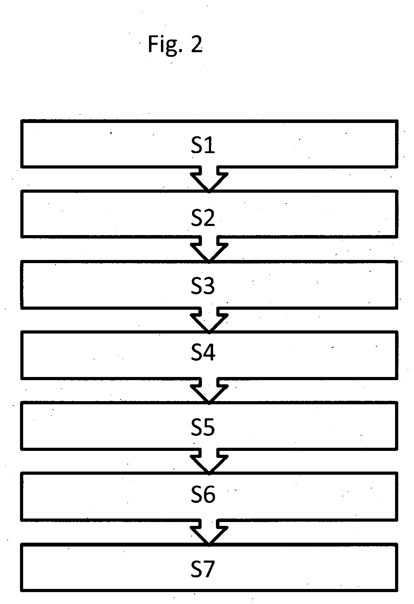

Fig. 1 zeigt ein Maschinenelement 1, bei dem ein Aufwertefaktor für eine Dehnungsmessung nach einer ersten Ausführung der vorliegenden Erfindung bestimmt wird, und Fig. 2 zeigt ein Flussdiagramm eines Verfahrens zum Bestimmen des Aufwertefaktors für eine Dehnungsmessung bei dem Maschinenelement 1. Bei dem dargestellten Maschinenelement 1 handelt es sich beispielhaft um eine Rotorschaufel einer Blisk für eine Gasturbine.

In einem ersten Schritt S1 wird eine Dehn-Mess-Einrichtung 2 an einem Mess-Oberflächenabschnitt 3 des Maschinenelements 1 angebracht. Die Dehn-Mess-Einrichtung 2 kann ein mechanischer Dehnungsmesstreifen sein.

Im folgenden Schritt S2 wird eine statische oder dynamische Verformung des Maschinenelements 1 bewirkt. Dabei kann eine Schwingung oder eine statische Kraft mittels eines Anregungssystems oder Aktuators in das Maschinenelement 1 eingeleitet werden.

Im folgenden Schritt S3 wird eine Dehnung im Mess-Oberflächenabschnitt 3 mithilfe der Dehn-Mess-Einrichtung 2 gemessen.

Im folgenden Schritt S4 wird eine Verschiebung zumindest eines Erfassungs-Oberflächenabschnitts 4 des Maschinenelements 1, der sich von dem Mess-Oberflächenabschnitt 3 unterscheidet, gemessen. Diese Messung kann durch ein flächiges, optisches Abtasten des Maschinenelements 1 erfolgen, zum Beispiel mittels Laservibrometrie oder durch ein Bildkorrelationsverfahren. Es ist denkbar, dass im Bereich des Mess-Oberflächenabschnitts 3 keine geeigneten Verschiebungen gemessen werden können. In diesem Fall kann eine Aussparung im Mess-Oberflächenabschnitt 3 vorgesehen werden, in die die Dehn-Mess-Einrichtung 2 eingesetzt werden kann.

Im folgenden Schritt S5 wird ein Verschiebungsfeld auf einer Oberfläche des Maschinenelements 1 auf der Grundlage eines Modells des Maschinenelements 1 und der gemessenen Verschiebung des zumindest eines Erfassungs-Oberflächenabschnitts 4 bestimmt. Vorzugsweise ist das Verschiebungsfeld vollflächig.

Im folgenden Schritt S6 wird ein Dehnungsfeld auf der Grundlage des bestimmten Verschiebungsfeldes und des Modells des Maschinenelements 1 bestimmt. Vorzugsweise ist das Dehnungsfeld vollflächig.

Im folgenden Schritt S7 wird ein Aufwertefaktor der Dehn-Mess-Einrichtung 2 auf der Grundlage des bestimmten Dehnungsfeldes und der gemessenen Dehnung im Mess-Oberflächenabschnitt 3 bestimmt. Der Aufwertefaktor wird vorzugsweise als ein Verhältnis einer maximalen Dehnung im Dehnungsfeld und der gemessenen Dehnung im Mess-Oberflächenabschnitt 3 bestimmt.

Das Modell des Maschinenelements 1 kann auf der Grundlage von nominalen und/oder insbesondere durch Reverse-Engineering erfassten Daten erstellt werden. Bei den nominalen Daten kann es sich um eine CAD-Datei handeln. Die durch Reverse-Engineering erfassten Daten können zum Beispiel durch ein dreidimensionales, optisches Abtasten des physikalischen Maschinenelements 1 durch Weißlichtinterferometrie erhalten werden. Der Vorteil des durch Reverse-Engineering erhaltenen Modells liegt darin, dass Fertigungsabweichungen, die das Maschinenelement 1 im Vergleich zu den Daten einer CAD-Datei hat, nicht berücksichtigt werden.

Gute Ergebnisse können erhalten werden, wenn das Modell des Maschinenelements 1 ein validiertes Modell des Maschinenelements 1 ist. Die Validierung kann zum Beispiel dadurch erfolgen, dass eine berechnete Dehnung mit einer gemessenen Dehnung verglichen wird.

Die Mess- und/oder Erfassungs-Oberflächenabschnitte 3, 4 und eine Orientierung der Dehn-Mess-Einrichtung 2 an dem Mess-Oberflächenabschnitt 3 können gezielt auf der Grundlage des Modells des Maschinenelements 1 bestimmt werden, zum Beispiel um eine möglichst große Beanspruchung oder Amplitude zu messen bzw. zu bestimmen. Weiter bevorzugt können Schwingungsmoden des Maschinenelements 1 auf der Grundlage des Modells des Maschinenelements 1 bestimmt werden, wobei der Mess-Oberflächenabschnitt 3 und die Orientierung der Dehn-Mess-Einrichtung 2 an dem Mess-Oberflächenabschnitt 3 zusätzlich auf der Grundlage der bestimmten Schwingungsmoden bestimmt werden.

Fig. 1 stellt das erfindungsgemäße Verfahren lediglich schematisch mit je einem Mess- und Erfassungs-Oberflächenabschnitt 3, 4 dar. In der Praxis können eine Vielzahl von Mess- und/oder Erfassungs-Oberflächenabschnitten 3, 4 vorhanden sein.

Eine erfindungsgemäße Vorrichtung zum Durchführen des erfindungsgemäßen Verfahrens hat die Dehn-Mess-Einrichtung 2 wie zum Beispiel den DMS, der dazu konfiguriert ist, an dem Mess-Oberflächenabschnitt 3 des Maschinenelements 1 angebracht zu werden; ein Mittel wie zum Beispiel das Anregungssystem oder den Aktuator, die dazu konfiguriert sind, eine statische oder dynamische Verformung des Maschinenelements 1 zu bewirken; ein Mittel wie zum Beispiel eine Rechenvorrichtung, die dazu konfiguriert ist, eine Dehnung im Mess-Oberflächenabschnitt 3 mithilfe der mechanischen Dehn-Mess-Einrichtung 2 zu messen; ein Mittel wie zum Beispiel eine optische Abtastvorrichtung, die dazu konfiguriert ist, eine Verschiebung des zumindest einen Erfassungs-Oberflächenabschnitts 4 des Maschinenelements 1, der sich von dem Mess-Oberflächenabschnitt 3 unterscheidet, zu messen; ein Mittel wie zum Beispiel die Rechenvorrichtung, die dazu konfiguriert ist, ein Verschiebungsfeld auf einer Oberfläche des Maschinenelements 1 auf der Grundlage eines Modells des Maschinenelements 1 und der gemessenen Verschiebung des zumindest eines Erfassungs-Oberflächenabschnitts 4 zu bestimmen; ein Mittel wie zum Beispiel die Rechenvorrichtung, die dazu konfiguriert ist, ein Dehnungsfeld auf der Oberfläche des Maschinenelements 1 auf der Grundlage des bestimmten Verschiebungsfeldes und des Modells des Maschinenelements 1 zu bestimmen; und ein Mittel wie zum Beispiel die Rechenvorrichtung, die dazu konfiguriert ist, einen Aufwertefaktor der Dehn-Mess-Einrichtung 2 auf der Grundlage des bestimmten Dehnungsfeldes und der gemessenen Dehnung im Dehn-Oberflächenabschnitt 3 zu bestimmen. Obwohl in der vorhergehenden Beschreibung exemplarische Ausführungen erläutert wurden, sei darauf hingewiesen, dass eine Vielzahl von Abwandlungen möglich ist. Außerdem sei darauf hingewiesen, dass es sich bei den exemplarischen Ausführungen lediglich um Beispiele handelt, die den Schutzbereich, die Anwendungen und den Aufbau in keiner Weise einschränken sollen. Vielmehr wird dem Fachmann durch die vorausgehende Beschreibung ein Leitfaden für die Umsetzung von mindestens einer exemplarischen Ausführung gegeben, wobei diverse Änderungen, insbesondere in Hinblick auf die Funktion und Anordnung der beschriebenen Bestandteile, vorgenommen werden können, ohne den Schutzbereich zu verlassen, wie er sich aus dem Ansprüchen ergibt.

### Bezugszeichenliste

- 1: Maschinenelement
- 2: Dehn-Mess-Einrichtung
- 3: Mess-Oberflächenabschnitt
- 4: Erfassungs-Oberflächenabschnitt

## Patentansprüche

1. Verfahren zum Bestimmen eines Aufwertefaktors für eine Dehnungsmessung bei einem Maschinenelement (1), mit den folgenden Schritten:
Anbringen (S1) einer Dehn-Mess-Einrichtung (2) an einem Mess-Oberflächenabschnitt (3) des Maschinenelements;
Bewirken (S2) einer statischen oder dynamischen Verformung des Maschinenelements (1);
Messen (S3) einer Dehnung im Mess-Oberflächenabschnitt (3) mithilfe der Dehn-Mess-Einrichtung (2);
Messen (S4) einer Verschiebung zumindest eines Erfassungs-Oberflächenabschnitts (4) des Maschinenelements (1), der sich von dem Mess-Oberflächenabschnitt (3) unterscheidet durch optisches Abtasten des Maschinenelements (1);
Bestimmen (S5) eines Verschiebungsfeldes auf einer Oberfläche des Maschinenelements (1) auf der Grundlage eines Modells des Maschinenelements (1) und der gemessenen Verschiebung des zumindest eines Erfassungs-Oberflächenabschnitts (4);
Bestimmen (S6) eines Dehnungsfeldes auf der Oberfläche des Maschinenelements (1) auf der Grundlage des bestimmten Verschiebungsfeldes und des Modells des Maschinenelements (1); und
Bestimmen (S7) eines Aufwertefaktors der Dehn-Mess-Einrichtung (2) auf der Grundlage der gemessenen Dehnung im Mess-Oberflächenabschnitt (3) und des bestimmten Dehnungsfeldes, wobei der Aufwertefaktor ein Verhältnis einer maximalen Dehnung im Dehnungsfeld und der gemessenen Dehnung im Mess-Oberflächenabschnitt (3) ist.

2. Verfahren nach einem der vorhergehenden Ansprüche, **dadurch gekennzeichnet, dass** das Modell des Maschinenelements (1) auf der Grundlage von nominalen und/oder insbesondere durch Reverse-Engineering erfassten Daten erstellt wird und/oder finite Elemente aufweist.

3. Verfahren nach einem der dem vorhergehenden Ansprüche, **dadurch gekennzeichnet, dass** das Modell des Maschinenelements (1) ein, insbesondere validiertes, Finite-Elemente-Modell des Maschinenelements (1) ist.

4. Verfahren nach einem der vorhergehenden Ansprüche, **gekennzeichnet durch** einen Schritt zum Bestimmen des Mess- und/oder Erfassungs-Oberflächenabschnitts (3, 4) und einer Orientierung der Dehn-Mess-Einrichtung (2) an dem Mess-Oberflächenabschnitt (3) auf der Grundlage des Modells des Maschinenelements (1).

5. Verfahren nach dem vorhergehenden Anspruch, **gekennzeichnet durch** einen Schritt zum Bestimmen von Schwingungsmoden des Maschinenelements (1) auf der Grundlage des Modells des Maschinenelements (1), wobei der Mess-Oberflächenabschnitt (3) und die Orientierung der Dehn-Mess-Einrichtung (2) an dem Mess-Oberflächenabschnitt (3) zusätzlich auf der Grundlage der bestimmten Schwingungsmoden bestimmt werden.

6. Verfahren nach einem der vorhergehenden Ansprüche, **dadurch gekennzeichnet, dass** der Schritt (S4) zum Messen der Verschiebung des zumindest einen Erfassungs-Oberflächenabschnitts (4) ein flächiges, optische Abtasten aufweist, insbesondere durch Laservibrometrie oder ein Bildkorrelationsverfahren.

7. Verfahren nach einem der vorhergehenden Ansprüche, **dadurch gekennzeichnet, dass** das Maschinenelement (1) eine Rotorschaufel einer Gasturbine und/oder eine Blisk ist.

8. Vorrichtung zum Bestimmen eines Aufwertefaktors für eine Dehnungsmessung bei einem Maschinenelement (1), mit:
einer Dehn-Mess-Einrichtung (2), die dazu konfiguriert ist, an einem Mess-Oberflächenabschnitt (3) des Maschinenelements (1) angebracht zu werden;
einem Mittel, das dazu konfiguriert ist, eine statische oder dynamische Verformung des Maschinenelements (1) zu bewirken;
einem Mittel, das dazu konfiguriert ist, eine Dehnung im Mess-Oberflächenabschnitt (3) mithilfe der Dehn-Mess-Einrichtung (2) zu messen;
einem Mittel, das dazu konfiguriert ist, eine Verschiebung zumindest eines Erfassungs-Oberflächenabschnitts (4) des Maschinenelements (1), der sich von dem Mess-Oberflächenabschnitt (3) unterscheidet, zu messen durch optisches Abtasten des Maschinenelements (1);
einem Mittel, das dazu konfiguriert ist, ein Verschiebungsfeld auf einer Oberfläche des Maschinenelements (1) auf der Grundlage eines Modells des Maschinenelements (1) und der gemessenen Verschiebung des zumindest eines Erfassungs-Oberflächenabschnitts (4) zu bestimmen;
einem Mittel, das dazu konfiguriert ist, ein Dehnungsfeld auf der Oberfläche des Maschinenelements (1) auf der Grundlage des bestimmten Verschiebungsfeldes und des Modells des Maschinenelements (1) zu bestimmen; und
einem Mittel, das dazu konfiguriert ist, einen Aufwertefaktor der Dehn-Mess-Einrichtung (2) auf der Grundlage der gemessenen Dehnung im Mess-Oberflächenabschnitt (3) und des bestimmten Dehnungsfeldes zu bestimmen,
wobei der Aufwertefaktor ein Verhältnis einer maximalen Dehnung im Dehnungsfeld und der gemessenen Dehnung im Mess-Oberflächenabschnitt (3) ist.

## Claims

1. Method for determining an enhancement factor for a strain measurement in a machine element (1), comprising the following steps:
Attaching (S1) a strain measurement device (2) to a measurement surface portion (3) of the machine element;
Causing (S2) a static or dynamic deformation of the machine element (1);
Measuring (S3) a strain in the measurement surface portion (3) using the strain measurement device (2);
Measuring (S4) a displacement of at least one detection surface portion (4) of the machine element (1), which differs from the measurement surface portion (3), by optically scanning the machine element (1);
Determining (S5) a displacement field on a surface of the machine element (1) on the basis of a model of the machine element (1) and the measured displacement of the at least one detection surface portion (4);
Determining (S6) a strain field on the surface of the machine element (1) on the basis of the determined displacement field and the model of the machine element (1); and
Determining (S7) an enhancement factor of the strain measurement device (2) on the basis of the measured strain in the measurement surface portion (3) and the determined strain field, wherein the enhancement factor is a ratio of a maximum strain in the strain field and the measured strain in the measurement surface portion (3).

2. Method according to any of the preceding claims, **characterized in that** the model of the machine element (1) is created on the basis of nominal data and/or data acquired in particular by reverse engineering, and/or has finite elements.

3. Method according to any of the preceding claims, **characterized in that** the model of the machine element (1) is an in particular validated finite element model of the machine element (1).

4. Method according to any of the preceding claims, **characterized by** a step for determining the measurement and/or detection surface portion (3, 4) and an orientation of the strain measurement device (2) on the measurement surface portion (3) on the basis of the model of the machine element (1).

5. Method according to the preceding claim, **characterized by** a step for determining vibration modes of the machine element (1) on the basis of the model of the machine element (1), wherein the measurement surface portion (3) and the orientation of the strain measurement device (2) on the measurement surface portion (3) are additionally determined on the basis of the determined vibration modes.

6. Method according to any of the preceding claims, **characterized in that** the step (S4) for measuring the displacement of the at least one detection surface portion (4) comprises planar, optical scanning, in particular by laser vibrometry or an image correlation method.

7. Method according to any of the preceding claims, **characterized in that** the machine element (1) is a rotor blade of a gas turbine and/or a blisk.

8. Device for determining an enhancement factor for a strain measurement in a machine element (1), comprising:
a strain measurement device (2) configured to be attached to a measurement surface portion (3) of the machine element (1);
a means configured to cause a static or dynamic deformation of the machine element (1);
a means configured to measure a strain in the measurement surface portion (3) using the strain measurement device (2);
a means configured to measure a displacement of at least one detection surface portion (4) of the machine element (1), which differs from the measurement surface portion (3), by optically scanning the machine element (1);
a means configured to determine a displacement field on a surface of the machine element (1) on the basis of a model of the machine element (1) and the measured displacement of the at least one detection surface portion (4);
a means configured to determine a strain field on the surface of the machine element (1) on the basis of the determined displacement field and the model of the machine element (1); and
a means configured to determine an enhancement factor of the strain measurement device (2) on the basis of the measured strain in the measurement surface portion (3) and the determined strain field, wherein the enhancement factor is a ratio of a maximum strain in the strain field and the measured strain in the measurement surface portion (3).

## Revendications

1. Procédé permettant de déterminer un facteur de revalorisation pour une mesure d'allongement sur un élément de machine (1), comportant les étapes suivantes :
montage (S1) d'un appareil de mesure d'allongement (2) sur une section de surface de mesure (3) de l'élément de machine ;
induction (S2) d'une déformation statique ou dynamique de l'élément de machine (1) ;
mesure (S3) d'un allongement dans la section de surface de mesure (3) à l'aide de l'appareil de mesure d'allongement (2) ;
mesure (S4), par balayage optique de l'élément de machine (1), d'un déplacement d'au moins une section de surface de détection (4) de l'élément de machine (1), laquelle section de surface de détection est différente de la section de surface de mesure (3) ;
détermination (S5) d'un champ de déplacement sur une surface de l'élément de machine (1) sur la base d'un modèle de l'élément de machine (1) et du déplacement mesuré de l'au moins une section de surface de détection (4) ;
détermination (S6) d'un champ d'allongement sur la surface de l'élément de machine (1) sur la base du champ de déplacement déterminé et du modèle de l'élément de machine (1) ; et
détermination (S7) d'un facteur de valorisation de l'appareil de mesure d'allongement (2) sur la base de l'allongement mesuré dans la section de surface de mesure (3) et du champ d'allongement déterminé, dans lequel le facteur de revalorisation est un rapport d'un allongement maximal dans le champ d'allongement à l'allongement mesuré dans la section de surface de mesure (3).

2. Procédé selon l'une des revendications précédentes, **caractérisé en ce que** le modèle de l'élément de machine (1) est créé sur la base de données nominales et/ou saisies en particulier par ingénierie inverse et/ou présente des éléments finis.

3. Procédé selon l'une des revendications précédentes,
**caractérisé en ce que** le modèle de l'élément de machine (1) est un modèle par éléments finis, en particulier validé, de l'élément de machine (1).

4. Procédé selon l'une des revendications précédentes, **caractérisé par** une étape permettant de déterminer la section de surface de mesure et/ou de détection (3, 4) et une orientation de l'appareil de mesure d'allongement (2) sur la section de surface de mesure (3) sur la base du modèle de l'élément de machine (1).

5. Procédé selon la revendication précédente, **caractérisé par** une étape permettant de déterminer des modes de vibration de l'élément de machine (1) sur la base du modèle de l'élément de machine (1), dans lequel la section de surface de mesure (3) et l'orientation de l'appareil de mesure d'allongement (2) sur la section de surface de mesure (3) sont en outre déterminées sur la base des modes de vibration déterminés.

6. Procédé selon l'une des revendications précédentes, **caractérisé en ce que** l'étape (S4) permettant de mesurer le déplacement de l'au moins une section de surface de détection (4) présente un balayage optique surfacique, en particulier par vibrométrie laser ou par un procédé de corrélation d'images.

7. Procédé selon l'une des revendications précédentes,
**caractérisé en ce que** l'élément de machine (1) est une aube de rotor d'une turbine à gaz et/ou un disque aubagé monobloc.

8. Dispositif permettant de déterminer un facteur de revalorisation pour une mesure d'allongement sur un élément de machine (1), comportant :
un appareil de mesure d'allongement (2) conçu pour être monté sur une section de surface de mesure (3) de l'élément de machine (1) ;
un moyen configuré pour induire une déformation statique ou dynamique de l'élément de machine (1) ;
un moyen configuré pour mesurer un allongement dans la section de surface de mesure (3) à l'aide de l'appareil de mesure d'allongement (2) ;
un moyen configuré pour mesurer, par balayage optique de l'élément de machine (1), un déplacement d'au moins une section de surface de détection (4) de l'élément de machine (1), laquelle surface de mesure de détection est différente de la section de surface de mesure (3) ;
un moyen configuré pour déterminer un champ de déplacement sur une surface de l'élément de machine (1) sur la base d'un modèle de l'élément de machine (1) et du déplacement mesuré de l'au moins une section de surface de détection (4) ;
un moyen configuré pour déterminer un champ d'allongement sur la surface de l'élément de machine (1) sur la base du champ de déplacement déterminé et du modèle de l'élément de machine (1) ; et
un moyen configuré pour déterminer un facteur de revalorisation de l'appareil de mesure d'allongement (2) sur la base de l'allongement mesuré dans la section de surface de mesure (3) et du champ d'allongement déterminé, dans lequel le facteur de revalorisation est un rapport d'un allongement maximal dans le champ d'allongement à l'allongement mesuré dans la section de surface de mesure (3).
